Europäisches Patentamt

European Patent Office

Office européen des brevets

(11) Veröffentlichungsnummer: **0 263 152**
**B1**

(12) **EUROPÄISCHE PATENTSCHRIFT**

(45) Veröffentlichungstag der Patentschrift: 23.01.91

(51) Int. Cl.⁵: **H 05 K 13/06**

(21) Anmeldenummer: 87902384.4

(22) Anmeldetag: 08.04.87

(86) Internationale Anmeldenummer:
PCT/DE87/00158

(87) Internationale Veröffentlichungsnummer:
WO 87/06424 22.10.87 Gazette 87/23

(54) WERKZEUG ZUM VERLEGEN UND ABLÄNGEN VON KABELN MIT HILFE EINES INDUSTRIEROBOTERS.

(30) Priorität: 08.04.86 DE 3611805

(43) Veröffentlichungstag der Anmeldung:
13.04.88 Patentblatt 88/15

(45) Bekanntmachung des Hinweises auf die
Patenterteilung:
23.01.91 Patentblatt 91/04

(84) Benannte Vertragsstaaten:
CH DE FR GB IT LI LU SE

(56) Entgegenhaltungen:
US-A-3 930 524
US-A-4 593 452

(73) Patentinhaber: KOMAX AG
Industriestrasse
CH-6036 Dierikon-Luzern (CH)

(72) Erfinder: EMMERICH, Herbert
Schulweg 6
D-7891 Weilheim (DE)
Erfinder: SCHLAICH, Gerd
Schellingstrasse 12
D-7255 Rutesheim (DE)

(74) Vertreter: Münich, Wilhelm, Dr. et al
Kanzlei Münich, Steinmann, Schiller
Willibaldstrasse 36/38
D-8000 München 21 (DE)

Courier Press, Leamington Spa, England.

## Beschreibung

### Technisches Gebiet

Die Erfindung bezieht sich auf ein Werkzeug zum Verlegen und Ablängen von Kabeln mit Hilfe eines Industrieroboters gemäß dem Oberbegriff des Patentanspruchs 1.

### Stand der Technik

Ein derartiges Werkzeug ist beispielsweise aus der älteren Patentanmeldung P 36 06 059.3 bekannt, zu der die vorliegende Anmeldung eine Zusatzanmeldung darstellt. Auf diese Patentanmeldung wird im übrigen zur Erläuterung aller hier nicht näher beschriebenen Einzelheiten ausdrücklich Bezug genommen.

Bei dem aus dieser älteren Patentanmeldung bekannten Werkzeug ist es nicht in einfacher Weise möglich, die zu verlegenden Kabel zwischen zwei Verlegevorgängen zu wechseln.

### Darstellung der Erfindung

Der Erfindung liegt die Aufgabe zugrunde, das in der älteren Patentanmeldung beschriebene Werkzeug derart weiterzubilden, daß das Wechseln der zu verlegenden Kabel ohne Aufwand möglich ist.

Eine erfindungsgemäße Lösung dieser Aufgabe ist mit ihren Weiterbildungen in den Patentansprüchen gekennzeichnet.

Erfindungsgemäß ist mindestens ein austauschbares Wechselrohr vorgesehen, in dem das Kabel geführt und insbesondere dann, wenn das Wechselrohr vom Werkzeug abgenommen und in einem Lager gelagert wird (Anspruch 7), festlegbar ist. Damit ist es möglich, das Wechselrohr zum Wechseln der verlegten Kabel mitsamt dem in ihm geführten Kabel abzunehmen. Diese Arbeit kann—im Gegensatz zum Einfädeln eines Kabels in einen Kabelschacht—ohne Probleme von einem Industrieroboter verrichtet werden. Durch den Klemmmechanismus, der das Kabel festlegt, wird verhindert, daß das Kabel beim Wechseln des Wechselrohr aus diesem gezogen wird.

Weiterbildungen der Erfindung sind in den Unteransprüchen gekennzeichnet.

Das erfindungsgemäße Werkzeug eignet sich insbesondere zum Verlegen mehrerer Kabel; hierzu sind soviele Wechselrohre vorgesehen, wie Kabel auf einmal verlegt werden sollen. Die Wechselrohre können dabei je nach Bedarf von dem Industrieroboter an dem Werkzeug angebracht werden (Anspruch 2).

Die Führung der Kabel in PTFE-Rohren setzt die Reibung beim Vorschieben und Zurückziehen der Kabel deutlich herab (Anspruch 4).

Auch bei der Verwendung mehrer Wechselrohre ist es ohne weiteres möglich, die Kabel auf beliebige Rastermaße, wie sie beispielsweise von Schneidklemmverbindern vorgegeben werden, durch entsprechende Verlegemodule zusammenzuführen. Hierbei ist es von Vorteil, die Verlegemodule austauschbar auszubilden, um mit einem Werkzeug verschiedene Rastermaße verlegen zu können.

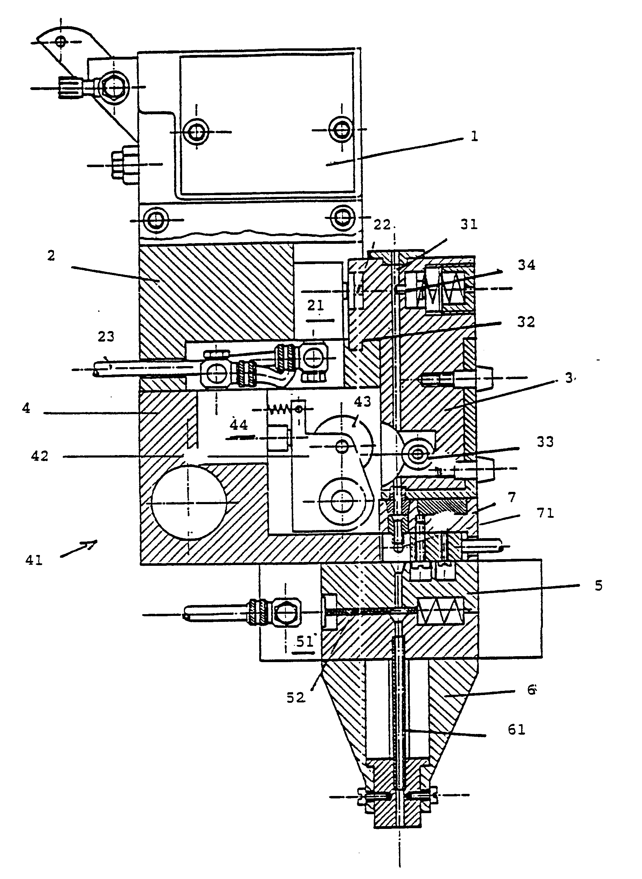

### Kurze Beschreibung der Zeichnung

Die Erfindung wird nachstehend anhand eines Ausführungsbeispiels unter Bezugnahme auf die einzige Figur der Zeichnung näher beschrieben.

### Weg zur Ausführung der Erfindung

Das erfindungsgemäße Werkzeug zum Verlegen und Ablängen von Kabeln mit Hilfe eines Industrieroboters weist einen Wechselflansch 1, ein Entriegelungsmodul 2 für die Kabel, ein Wechselrohr 3 zur Kabelführung, ein Vorschubmodul 4 für die Kabel, ein Ablängmodul 5, ein Verlegemodul 6 sowie ein Modul 7 für die Anwesenheitskontrolle der Kabel auf.

Im Folgenden sollen zunächst der Aufbau der einzelnen Module bzw. Bauelemente und anschließend die Funktionsweise des erfindungsgemäßen Werkzeugs besprochen werden.

Der Wechselflansch 1 stellt die Schnittstelle zwischen Industrieroboter und Werkzeug dar, so daß je nach Bedarf verschiedene Werkzeuge mit dem Industrieroboter gehandhabt werden können. Über den Wechselflansch 1 erfolgt ferner die Versorgung des Werkzeugs mit elektrischer und pneumatischer Energie vom Industrieroboter.

Das Wechselrohr dient zur Kabelführung. Insgesamt können am Verlegewerkzeug mehrere, beispielsweise drei Wechselrohre angedockt werden, von denen jedes ein Kabel aufnimmt und führt. Von diesen Wechselrohren ist in der Figur nur eines dargestellt. Besondere Formelemente, bezüglich deren Ausgestaltung auf die Zeichnung verwiesen wird, erlauben gemeinsam mit einer kraftschlüssigen Verbindung und/oder einer Magnetplatte das Andocken des Wechselrohrs an das Verlegewerkzeug sowie an die jeweiligen Lagerplätze für die einzelnen Wechselrohre.

Die Kabel werden beim Eintritt in das jeweilge Wechselrohr 3 über eine PTFE-Buchse 31 geführt, die die Reibungskräfte beim Verlegevorgang vermindert. Ferner ist in jedem Wechselrohr ein nicht angetriebenes Reibrad 33 für die Kabelführung vorgesehen.

Im Wechselrohr befindet sich ein Klemmmechanismus 34, der das in das Wechselrohr eingeführte Kabel in seiner Lage sichert, so daß dieses nicht aus dem Rohr herausrutschen kann.

Wenn das Wechselrohr am Verlegewerkzeug angedockt wird, wird über ein Entriegelungsmodul 2, das bei dem dargestellten Ausführungsbeispiel einen Pneumatikzylinder 21 aufweist, der Verriegelungs- bzw. Klammechanismus entriegelt. Dies ist schematisch durch die Pneumatik-Bauelemente 23 und die Entriegelungsstößel 22 dargestellt.

Das Vorschubmodul 4 weist einen nicht im einzelnen dargestellten Elektromotor 41 mit einem Getriebe 42 auf. Der Elektromotor wird über einen nicht dargestellten Regelkreis angesteuert, so daß jederzeit der Vorschub exakt vorgegeben und programmiert werden kann. Außerdem kann die Drehrichtung des Motors umgekehrt werden, so daß das Kabel vor- und rückgefördert werden kann.

Zum Verlegen mehrerer Kabel treibt der Motor über das Getriebe 42 beispielsweise drei Reibräder 43, von denen in der Figur wiederum nur eines dargestellt ist, für drei zu verlegende Kabel an. Diese Reibräder können unabhängig voneinander mit Hilfe eines Pneumatikzylinders 44 gegen das nicht angetriebene Rad 33 im Wechselrohr 3 gepreßt werden. Hierdurch können die drei Kabel unabhängig voneinander vor- und rückgefördert werden.

Mit Hilfe des Moduls 7 für die Anwesenheitskontrolle der Kabel kann für jeden Kabelschacht einzelnen abgefragt werden, ob sich im Kabelschacht ein Kabel befindet. Sollte ein Kabel während des Verlegevorgangs reißen, so wird dies mittels des Moduls 7 erkannt. Das Modul gibt eine Fehlermeldung an den Industrieroboter aus und unterbricht gleichzeitig den Verlegevorgang. Bei dem gezeigten Ausführungsbeispiel erfolgt die Anwesenheitskontrolle des Kabels mit Hilfe einer nur schematisch angedeuteten Lichtschranke 71.

Das Ablängmodul 5 besteht bei dem gezeigten Ausführungsbeispiel, bei dem drei Kabel verlegt werden können, aus drei Pneumatikzylindern 51, von denen nur einer dargestellt ist und die unabhängig voneinander angesteuert werden können. Die Zylinder 51 betätigen jeweils einen Scheiber 52, mit dem die Kabel an definierter Stelle abgeschnitten werden können. Im Verlegemodul 6 werden die einzelnen (bei dem gezeigten Ausführungsbeispiel drei Kabel) durch drei verschiedene PTFE-Schläuche 61 auf das gewünschte Rastermaß, beispielsweise das Rastermaß eines Schneidklemmverbinders zusammengeführt. Die Kabel werden hierdurch in dem gewünschten Rastermaß verlegt.

Die Ausbildung des Führungsschlauchs 61 aus dem Werkstoff PTFE gewährleistet geringe Reibungskräfte beim Verlegen des Kabels. Die geometrische Anordnung der einzelnen Führungsbohrungen in dem Verlegemodul 6 ist dabei so gewählt, daß verschiedene Kabeldurchmesser mit dem Verlegemodul verlegt werden können. Die genaue Positionierung der Kabel ist auch, wenn sie unterschiedlichen Querschnitt haben, hierdurch sichergestellt.

Im Folgenden soll kurz die Funktionsweise des erfindungsgemäßen Werkzeugs beschrieben werden.

In der Ausgangsstellung befinden sich alle Kabel-Wechselrohre 3 in einem dafür vorgesehenen Speicher auf verschiedenen Speicherplätzen. Mit Hilfe des Industrieroboters werden mehrere, beispielsweise drei beliebige Wechselrohre an das Werkzeug angedockt. Über die Vorschubeinheit werden die Kabel in Richtung verlegerohr gefördert, bis sie ein definiertes Stück as dem Verlegewerkzeug herausschauen. Mit Hilfe des Industrieroboters werden dann die Kabelenden in einer Haltevorrichtung, beispielsweise einem Schneidklemmverbinder fixiert.

Anschließend wird das Reibrad weggeklappt und der Klemmmechanismus im Wechselrohr entriegelt. Der Industrieroboter verfährt nun gemäß der vorprogrammierten Bahn. Die Kabel werden hierbei vom Industrieroboter durch das Verlegewerkzeug gezogen.

Nach Beendigung des Verlegevorgangs werden die Kabel abgeschnitten. Der Verlegevorgang mit denselben Kabeln (und Wechselrohren) kann dann an beliebiger Stelle wieder aufgenommen werden.

Natürlich ist es auch möglich, eines oder mehrere der Wechselrohre unabhängig von den anderen Wechselrohren bzw. Kabeln zu wechseln. Zum Abnehmen des Wechselmoduls wird das betreffende Kabel festgeklemmt und abgeschnitten. Anschließend wird das Kabel durch das Fördermodul soweit zurückgefördert, daß sich das Kabel nur noch im Wechselrohr befindet. Danach kann der Austauschvorgang stattfinden.

Vorstehend ist die Erfindung anhand eines Ausführungsbeispiels näher beschrieben worden; innerhalb des allgmeinen Erfindungsgedankens sind selbstverständlich die verschiedensten Modifikationen möglich, wie sie beispielsweise in der Patentanmeldung P 36 06 059.3 beschrieben sind.

**Patentansprüche**

1. Werkzeug zum Verlegen und Ablängen von Kabeln mit Hilfe eines Industrieroboters, das in Kabelvorschubrichtung gesehen einen Wechselflansch (1) zum Anbringen des Werkzeugs an einem Industrieroboter, ein Vorschubmodul (4) zum Vorschieben des Kabels, ein Ablängmodul (5) zum Ablängen des Kabels und ein Verlegemodul (7) aufweist, dadurch gekennzeichnet, daß mindestens ein austauschbares Wechselrohr (3) vorgesehen ist, in dem das Kabel verschiebbar geführt und mit Hilfe eines Klemmechanismus (34) festlegbar ist.

2. Werkzeug nach Anspruch 1, dadurch gekennzeichnet, daß mehrere Wechselrohre (3) zum Verlegen mehrerer Kabel vorgesehen sind, die an das Werkzeug mit Hilfe des Industrieroboters andockbar sind.

3. Werkzeug nach Anspruch 1 oder 2, dadurch gekennzeichnet, daß ein Entriegelungsmodul (2) vorgesehen ist, das den Klemmechanismus (34) beim Anbringen des Wechselrohrs (3) an dem Werkzeug löst.

4. Werkzeug nach einem der Ansprüche 1 bis 3, dadurch gekennzeichnet, daß das Kabel in dem Wechselrohr (3) in einem PTFE-Rohr (31) geführt ist.

5. Werkzeug nach einem der Ansprüche 1 bis 4, dadurch gekennzeichnet, daß jedem Wechselrohr (3) ein Modul (7) zugeordnet ist, das das Vorhandensein eines Kabels in dem entsprechenden Wechselrohr (3) überwacht.

6. Werkzeug nach einem der Ansprüche 1 bis 5, dadurch gekennzeichnet, daß das Modul (7) eine Lichtschranke aufweist.

7. Werkzeug nach einem der Ansprüche 1 bis 6, dadurch gekennzeichnet, daß die Wechselrohr bei Nichtgebrauch mit eingesetztem Kabel in einem Lager aufbewahrt werden, aus dem sie der Industrieroboter entnimmt.

8. Werkzeug nach einem der Ansprüche 1 bis 7, dadurch gekennzeichnet, daß die in einer Mehrzahl von Wechselrohren (3) geführten Kabel in dem Verlegemodul (6) auf das gewünschte Rastermaß zusammengeführt werden.

9. Werkzeug nach einem der Ansprüche 1 bis 8, dadurch gekennzeichnet, daß das Vorschubmodul (4) einen umsteuerbaren Motor aufweist, der das in dem jeweiligen Wechselrohr (3) geführte Kabel vor- und zurückschiebt.

10. Werkzeug nach einem der Ansprüche 1 bis 9, dadurch gekennzeichnet, daß der Motor jedes Kabel einzeln und unabhängig von den anderen Kabeln nach einem bestimmten Ablaufprogramm verschiebt.

11. Werkzeug nach einem der Ansprüche 1 bis 10, dadurch gekennzeichnet, daß das Wechselrohr an dem Werkzeug und/oder dem Lagerplatz durch formschlüssigen Eingriff und/oder mit Hilfe von Magnetplatten befestigbar ist.

## Revendications

1. Outil de pose et de tronçonnage de câbles à l'aide d'un robot industriel, comprenant, en direction d'avance du câble, une collerette interchangeable (1) pour le montage de l'outil à un robot industriel, un module d'avance (4) pour l'avancement dudit câble, un module de tronçonnage (5) pour tronçonner ledit câble, et un module de pose (7), caractérisé en ce qu'au moins un tube échangeable (3) est pourvu au dedans duquel ledit câble est guidé à déplacement et se peut fixer au moyen d'un mécanisme de serrage (34).

2. Outil selon la Revendication 1, caractérisé en ce que plusieurs tubes échangeables (3) sont pourvus pour la pose d'une pluralité de câbles appropriés à s'accoster audit outil au moyen dudit robot industriel.

3. Outil selon la Revendication 1 ou 2, caractérisé en ce qu'un module de déverrouillage (2) est pourvu pour le desserrage dudit mécanisme de serrage (34) quand ledit tube échangeable (3) est monté audit outil.

4. Outil selon quelconque des Revendications 1 à 3, caractérisé en ce que ledit câble est guidé dans un tube en PTFE (31) au dedans dudit tube échangeable (3).

5. Outil selon quelconque des Revendications 1 à 4, caractérisé en ce qu'un module (7) est associé à chacun desdits tubes échangeables (3) pour la surveillance de la présence d'un câble dans le tube échangeable (3) respectif.

6. Outil selon quelconque des Revendications 1 à 5, caractérisé en ce que ledit module (7) comprend un barrage photoélectrique.

7. Outil selon quelconque des Revendications 1 à 6, caractérisé en ce que lesdits tubes échangeables, quand ils sont hors de service, sont emmagasinés, à câble y logé, dans un dépôt d'où ledit robot industriel les prélève.

8. Outil selon quelconque des Revendications 1 à 7, caractérisé en ce que les câbles guidés dans une pluralité de tubes échangeables (3) sont abouchés dans ledit module de pose (6) à la dimension modulaire désirée.

9. Outil selon quelconque des Revendications 1 à 8, caractérisé en ce que ledit module d'avance (4) comprend un moteur réversible qui avance et recule ledit câble guidé dans le tube échangeable (3) respectif.

10. Outil selon quelconque des Revendications 1 à 9, caractérisé en ce que ledit moteur déplace chacun desdits câbles individuellement et indépendemment des autres câbles à programmation déterminée des opérations.

11. Outil selon quelconque des Revendications 1 à 10, caractérisé en ce que ledit tube échangeable se peut fixer audit outil et/ou la place de dépôt par prise crabotée et/ou au moyen d'une armature magnétique.

## Claims

1. Tool for laying and cutting cables using an industrial robot, which, seen in the cable feed direction, comprises an interchangeable flange (1) for attachment of the tool at an industrial robot, a feed module (4) for cable feed, a cutting module (5) for cutting said cable, and a laying module (7), characterized in that at least one interchangeable tube (3) is provided which is adapted to be exchanged and wherein said cable is guided for displacement and may be secured in its position by means of a clamping mechanism (34).

2. Tool according to Claim 1, characterized in that several interchangeable tubes (3) are provided for laying a plurality of cables which are adapted to be docked to said tool by means of said industrial robot.

3. Tool according to Claim 1 or 2, characterized in that a release module (2) is provided to release said clamping mechanism (34) when said interchangeable tube (3) is attached to said tool.

4. Tool according to any of Claims 1 to 3, characterized in that said cable is guided within a PTFE tube (31) inside said interchangeable tube (3).

5. Tool according to any of Claims 1 to 4, characterized in that one module (7) each is associated with each of said interchangeable tubes (3) for monitoring the presence of a cable in the respective interchangeable tube (3).

6. Tool according to any of Claims 1 to 5, characterized in that said module (7) includes a light barrier.

7. Tool according to any of Claims 1 to 6, characterized in that when they are not in use said interchangeable tubes, with said cables inserted therein, are stocked in a storage place for removal by said industrial robot.

8. Tool according to any of Claims 1 to 7, characterized in that the cables guided in a plurality of interchangeable tubes (3) are united in said laying module (6) so as to achieve the desired grid pattern.

9. Tool according to any of Claims 1 to 8, characterized in that said feed module (4) includes

EP 0 263 152 B1

a reversible motor for advancing and retracting the cable guided in the respective interchangeable tube (3).

10. Tool according to any of Claims 1 to 9, characterized in that said motor displaces each cable separately and independently of the other cables in accordance with a predetermined operating cycle program.

11. Tool according to any of Claims 1 to 10, characterized in that said interchangeable tube is adapted to be attached to said tool and/or said storage place by positive engagement and/or by means of magnetic plates.